# EUROPEAN PATENT SPECIFICATION

(11) **EP 1 914 763 B1**
(45) Date of publication and mention of the grant of the patent: **09.01.2013**
(21) Application number: 06021727.0
(22) Date of filing: 17.10.2006
(51) Int. Cl.: H02K 3/26, H02K 41/035, G11B 7/09, H01F 27/28

(54) **Printed circuit board having printed coils thereon**
Leiterplatte mit gedruckten Wicklungen
Circuit imprimé avec des enroulements imprimés

(43) Date of publication of application: 23.04.2008
(73) Proprietor: Harman Becker Automotive Systems GmbH, 76307 Karlsbad (DE)
(72) Inventor: Suzuki, Tsuneo, 78087 Mönchweiler (DE); Dupper, Rolf, 78050 VS-Villingen (DE)
(74) Representative: Grünecker, Kinkeldey, Stockmair & Schwanhäusser

(56) References cited:
- EP-A- 1 339 051
- EP-A2- 1 221 758
- FR-A1- 2 822 879
- US-A1- 2003 043 725
- US-A1- 2005 060 732

## Description

### Field of the Invention

The present invention relates to a printed circuit board having printed coils thereon, and to a method of manufacturing same. Such a printed circuit board can be implemented particularly in an actuator for an optical pick up in an optical recording and/or reproducing apparatus. An application in hard drives or electrical adjustment drives can also be considered.

### Background of the Invention

Generally, an optical pickup is used for an optical recording and/or reproducing apparatus. The optical pickup moves over an optical information storage medium, such as an optical disk, in a radial direction of the optical disk and records/reproduces information onto/from the optical disk in a non-contacting way.

The optical pickup needs an optical pickup actuator driving an objective lens in a tracking direction and a focus direction, and optionally, in a tilt direction, to make light emitted from a light source, usually a laser source, form a light spot at a correct position on the optical disk.

As the storage capacity of the optical disk increases, a numerical aperture of the objective lens increases, which causes an aberration, when the optical disk is tilted with respect to the objective lens. A reproducing capability of the optical pickup actuator decreases due to the increasing numerical aperture, and the increase of the numerical aperture causes writing signals of the optical disk to deteriorate due to the deformation of a pit formed on the optical disk in an information writing operation.

In order to overcome the above problem, a tilt error, as well as a focusing and tracking error, has to be compensated. Thus, the optical pickup actuator is moved in the tilt direction in addition to the tracking and focus directions.

A conventional optical pickup actuator comprises a lens holder movably installed at a base, a suspension supporting the lens holder to move with respect to the base, and a magnetic circuit installed to face the lens holder and the base. Such optical pickup actuator moves at least in a tracking direction, that is radial across the optical disk, and a focus direction, that is perpendicular to the surface of the optical disk.

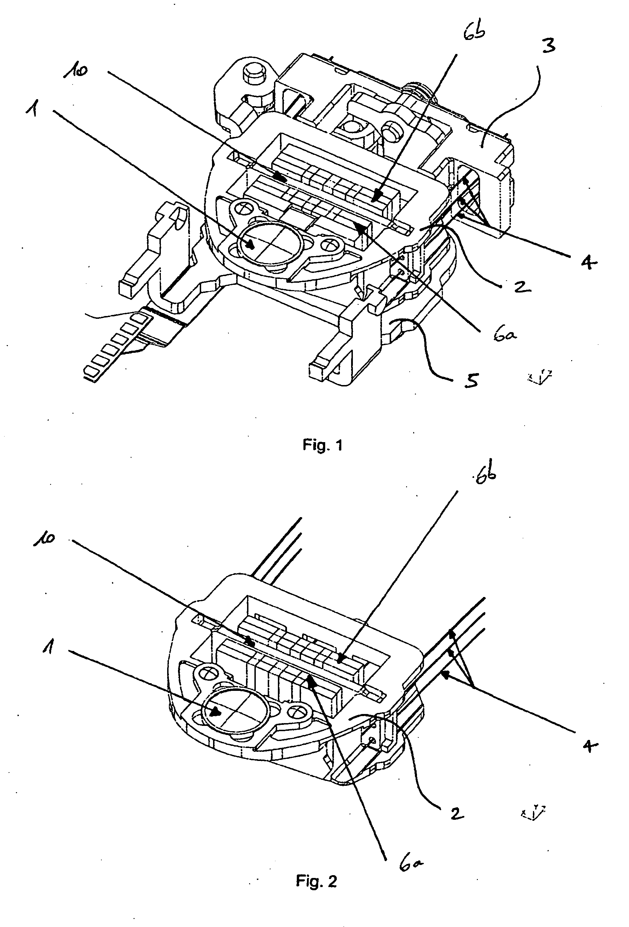

Fig. 1 shows a perspective view of such an optical pickup actuator according to the state of the art. The optical pickup actuator comprises an objective lens 1 that is mounted on a lens holder 2. It further comprises a support member 4, an end of which is fixed at a side of the lens holder 2 and the other end of which is fixed at a holder 3 that is provided on a base 5. The lens holder 2 is movable with respect to the base 5.

A printed circuit board 10 having magnetic circuits arranged on a surface thereof is fixed on the lens holder 2, and is arranged between two magnets 6a and 6b which are fixed on the base 5. The printed circuit board 10 is movable along the y-direction (focusing direction), x-direction (tracking direction), or in a tilt direction within the plane y, z or within the plane x, y.

Fig. 2 shows a perspective view of the lens holder 2 and printed circuit board 10 mounted between the magnets 6a, 6b as shown in Fig. 1, but without the holder 3 and base 5 being represented.

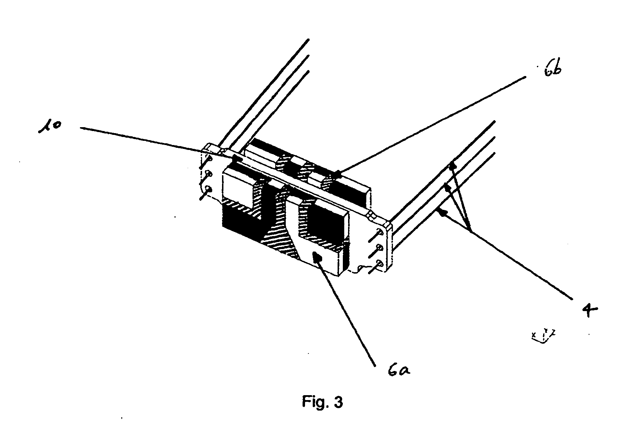

Fig. 3 shows a perspective view of the printed circuit board 10 arranged between the two magnets 6a and 6b. The magnets 6a and 6b are 8-pole magnets, wherein the portions represented in black correspond to the north pole and the portions represented in white to the south pole. The neutral portions are hatched. The first magnet 6a and second magnet 6b are arranged such that a pole of the first magnet, be it the north or south pole, faces the opposite pole of the second magnet 6b.

In conventional optical pickups, the magnetic circuits on the surface of the printed circuit boards are typically realized using wound coils. However, in more recent systems, the magnetic circuits have been imprinted on the printed circuit board. This has allowed to reduce the volume of the actuator as well as its weight by suppressing the need for bulky coil windings. In the following, typical printed coil patterns will be described.

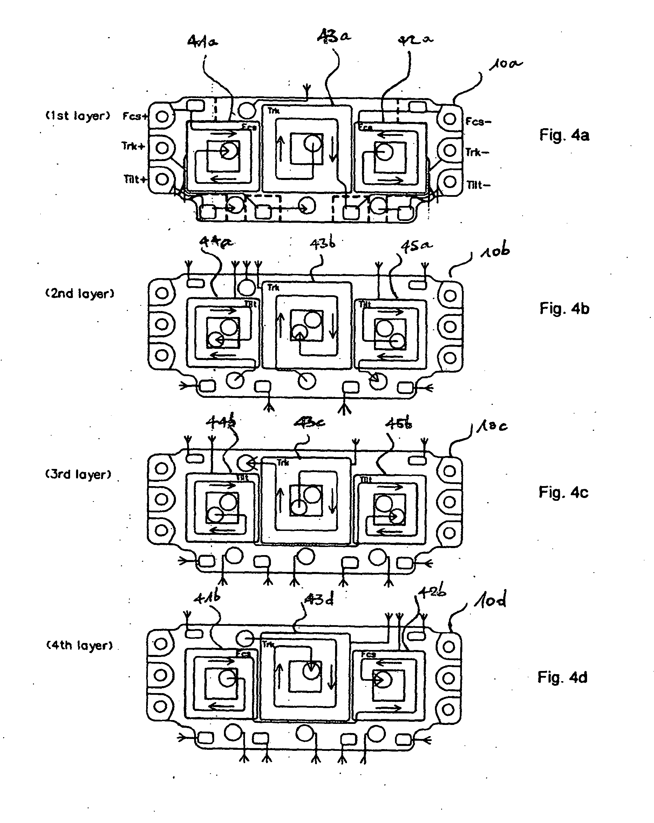

A printed circuit board in an optical pickup actuator typically comprises a plurality of layers of magnetic circuits. An example will be illustrated with respect to Figs. 4a, 4b, 4c and 4d, which shows a multi-layered arrangement of magnetic circuits having coil windings printed on a surface thereof, the layers of magnetic circuits being separated by insulating layers from each other, for instance by epoxy layers.

Fig. 4a represents a first layer 10a, wherein three magnetic circuits 41 a, 42a, 43a are represented, each of which comprising coil windings that are wound around an axis that is essentially perpendicular to a plane of the first layer 10a. In Fig. 4a, the first magnetic circuit 41 a and second magnetic circuit 42a, arranged on both ends of the first layer 10a, are focus coil windings. The third magnetic circuit 43a, arranged between the first and second magnetic circuit 41 a, 42a, is a tracking coil winding. The first, second and third magnetic circuit 41 a, 42a, 43a are each connected to terminals, on which input signals are applied.

Fig. 4b shows a second layer 10b of the multi-layered arrangement of a printed circuit board, wherein a fourth and fifth magnetic circuit 44a, 45a are arranged on both sides of the second layer 10b. A sixth magnetic circuit 43b is arranged between the fourth and fifth magnetic circuits 44a, 45a. The fourth and fifth magnetic circuits 44a, 45a are tilt coil windings, whereas the sixth magnetic circuit 43b is a tracking coil winding. As apparent from Figs. 4a and 4b, through-holes are arranged on the first and second layers 10a, 10b to allow for a signal input at one of the terminals and going through a coil winding of the first layer 10a to be transmitted to the corresponding coil winding of the second layer 10b.

Fig. 4c shows a third layer 10c comprising a seventh and eighth magnetic circuit 44b and 45b that are tilt coil windings. The third layer 10c further comprises a ninth magnetic circuit 43c that is a tracking coil winding. Fig. 4d shows a fourth layer 10d of the multi-layered arrangement, comprising a tenth and eleventh magnetic circuit 41 b, 42b that are focus coil windings, and a twelfth magnetic circuit 43d that is a tracking coil winding.

However, such a multi-layered arrangement of magnetic circuits, in order to enable the focusing, tracking and tilting functions, has a complicated structure. Further, this complicated structure of the printed circuit board results into a complicated structure of the permanent magnets required for creating the electro-magnetic forces. Indeed, as apparent from Fig. 3, the magnets 6a and 6b are 8-pole magnets, which structure is rather complicated, thereby leading to high manufacturing costs.

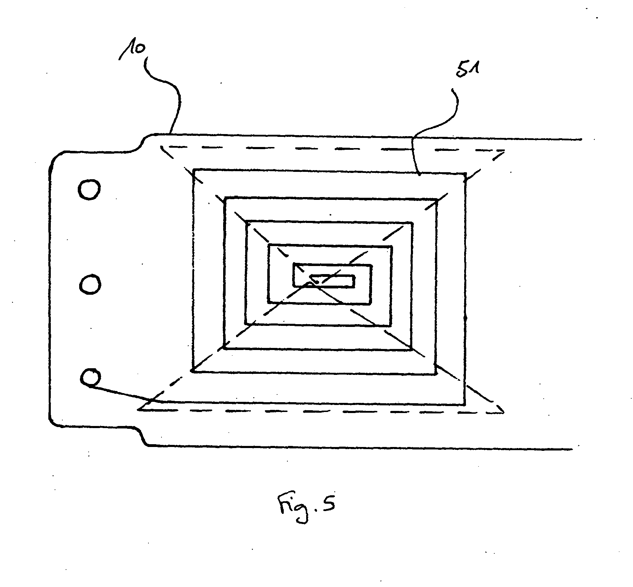

Further, in the printed circuit boards having printed coil windings imprinted on a surface thereof according to the art, the magnetically efficient domains are relatively small in comparison to the total surface of the printed coil windings, which leads to a low magnetic efficiency. An example will be given with respect to fig. 5.

Fig. 5 shows a schematic representation of a portion of one layer of a printed circuit board, in particular one coil winding 51. The hatched areas in Fig. 5 show the magnetically active domains in the coil winding 51, that is the domains of the coil winding 51 which have an orientation of the current flowing through them such that, when placed in the magnetic field produced by the magnets 6a and 6b shown in Fig. 3, they contribute to the creation of an electromagnetic force to move the printed circuit board. The other domains, that is the domains outside the hatched area, do not contribute to the creation of such an electromagnetic force but only ensure electrical connection. Consequently, the coil windings arranged on a printed circuit board in an optical pickup actuator according to the art have some domains that do not provide any contribution to the electromagnetic force, thereby leading to a loss of space on the printed circuit board and a decrease of the magnetic efficiency.

US 2005/0060732 A1 describes an integrated circuit board used as a bobbin using a printed circuit board manufacturing technology and integrally formed with a winding coil in a monolithic body. The bobbin includes the printed circuit board, a plurality of tracking and focusing circuit patterns formed on both surfaces of the printed circuit board, and a plurality of via holes formed on the printed circuit board to electrically connect the tracking and focusing circuit patterns with each other.

EP 1 339 051 A2 describes an optical pick up actuator having a magnetic driving portion which includes at least one fine pattern coil.

US 2003/0043725 A1 describes an electromagnetically controlled drive system comprising an electromagnetic element comprising conductive coils for generating an electromagnetic field. The coils may comprise conductive wires spirally wound about a support member, thereby forming a generally flattened-shaped coil. The coil may be spirally wound about a support member in a direction extending substantially along a certain axis, thereby forming the coil extending substantially the perpendicular axis.

FR 2822879 A1 discloses apparatuses of actuating of sliding mounted components on stationary members, in particular used with each of the motor vehicles. Parallel electric wires are mounted on the component and means to generate a magnetic field are mounted on a stationary member of the vehicle. The component can be a window pane and the stationary member of the vehicle is a door equipped with at least a guide rail of a cursor supporting the window pane, and the means to generate the magnetic field can consist of permanent magnets or electromagnets.

EP 1221758 A2 describes two layers with conducting paths, which are placed on a phase parallel to the trajectory phase of the revolution motion on which currents from an external power supply flow via a lead wire through these paths in intersecting directions with a phase difference of 90° to each other. The conducting paths are attached to a movable member, which revolves with an electromagnetic force generated by an intersection between the currents flowing through the conducting paths and the magnetic field produced by the permanent magnet.

### Summary of the Invention

An object of the invention is to provide a printed circuit board that allows for an improved magnetic efficiency.

This object is solved by the subject matter of the independent claims. Preferred embodiments are subject matter of the dependent claims.

One embodiment of the invention provides a non-conductive medium with a pattern of electrically conductive material arranged thereon, movable when positioned in a magnetic field, wherein said pattern of electrically conductive material comprises a first layer of a plurality of linear conductive paths arranged on the non-conductive medium parallel to a first axis, each of said plurality of linear conductive paths connecting at least a first terminal and a second terminal arranged on the non-conductive medium, and the linear conductive paths, when an electrical current flows between the at least first terminal and second terminal, are adapted to generate an electromagnetic force such that the non-conductive medium moves along a second axis that is perpendicular to the first axis. said medium further characterized according to the present claim 1.

According to an embodiment of the invention, the non-conductive medium further comprises a second layer of a plurality of second linear conductive paths, wherein the plurality of second linear conductive paths of the second layer are arranged parallel to a third axis, each of said plurality of second linear conductive paths connecting at least a third terminal and a fourth terminal arranged on the non-conductive medium, and the second linear conductive paths, when an electrical current flows between the at least third terminal and fourth terminal, are adapted to generate an electromagnetic force such that the non-conductive medium moves along a fourth axis that is perpendicular to the third axis.

According to another embodiment of the invention, the first layer of first linear conductive paths lies along a first plane defined by the first axis and the second axis, the second layer of second linear conductive paths lies along a second plane defined by the third axis and the fourth axis, and the first plane is parallel to the second plane.

According to yet another embodiment of the invention, the non-conductive medium further comprises a first non-conductive layer, that is adapted to electrically insulate the first and second layer of linear conductive paths from one another, wherein the second layer of linear conductive paths is arranged on the first non-conductive layer.

According to an embodiment of the invention, the first non-conductive layer is an epoxy layer.

According to another embodiment of the invention, the set of the first layer of first linear conductive paths and second layer of second linear conductive paths is arranged on each side of the non-conductive medium.

According to yet another embodiment of the invention, the first layer of linear conductive paths is arranged on one side of the non-conductive medium and the second layer of linear conductive paths is arranged on the other side of the non-conductive medium.

According to an embodiment of the invention, the first, second, third and fourth terminal are a first, second, third and fourth conductive strip, respectively.

According to another embodiment of the invention, the first axis of the first layer is arranged perpendicularly to the third axis of the second layer of linear conductive paths.

According to yet another embodiment of the invention, the non-conductive medium further comprises a third and a fourth layer of a plurality of respective third and fourth linear conductive paths, wherein said third linear conductive paths and fourth linear conductive paths are arranged on the non-conductive medium parallel respectively to a fifth axis and a sixth axis, said third and fourth linear conductive paths both connect a fifth terminal and a sixth terminal arranged on the non-conductive medium, and said third and fourth linear conductive paths, when an electrical current flows between the fifth and the sixth terminal, are adapted to generate respective electromagnetic forces having an opposed direction such that the non-conductive medium rotates about a seventh axis that is perpendicular to a plane of the non-conductive medium.

According to an embodiment of the invention, the third and fourth layer of respective third and fourth linear conductive paths are arranged in a same plane parallel to the plane of the non-conductive medium, the third and fourth layer of linear conductive paths are arranged on opposite ends of the non-conductive medium, and are essentially symmetrical to each other with respect to the seventh axis, and the fifth and sixth axis are parallel to each other.

According to another embodiment of the invention, the fifth terminal is adapted to connect the furthest ends, from the seventh axis, of the fifth and sixth linear conductive paths, and the sixth terminal is adapted to connect the nearest ends, from the seventh axis, of the fifth and sixth linear conductive paths, so that said third and fourth linear conductive paths, when an electrical current flows between the fifth and the sixth terminal, generate respective electromagnetic forces such that the non-conductive medium rotates about the seventh axis perpendicular to the plane of the non-conductive medium.

According to yet another embodiment of the invention, the fifth and sixth terminal are a fifth and sixth conductive strip, respectively.

According to an embodiment of the invention, the first layer of first linear conductive paths is arranged in a first plane, and the second layer of second linear conductive paths and the third and fourth layer of third and fourth linear conductive paths, respectively, are arranged in a second plane.

According to another embodiment of the invention, the first layer of first linear conductive paths and the third and fourth layer of third and fourth linear conductive paths, respectively, are arranged in a third plane and the second layer of second linear conductive paths is arranged in a fourth plane.

According to yet another embodiment of the invention, the first plane and second plane are arranged on one side of the non-conductive medium, and a second non-conductive layer is arranged between the first and second plane.

According to an embodiment of the invention, the set of the first and second plane is arranged on each side of the non-conductive medium.

According to another embodiment of the invention, the third plane and fourth plane are arranged on one side of the non-conductive medium, and a third non-conductive layer is arranged between the third and fourth plane.

According to yet another embodiment of the invention, the set of the third and fourth plane is arranged on each side of the non-conductive medium.

According to an embodiment of the invention, the first plane is arranged on one side of the non-conductive medium, and the second plane is arranged on the other side of the non-conductive medium.

According to another embodiment of the invention, the third plane is arranged on one side of the non-conductive medium, and the fourth plane is arranged on the other side of the non-conductive medium.

According to yet another embodiment of the invention, the pattern of electrically conductive material is printed on a surface of the non-conductive medium.

Another embodiment of the invention provides a system comprising a non-conductive medium with a pattern of electrically conductive material arranged thereon, and a first magnet and a second magnet, wherein the non-conductive medium with the pattern of electrically conductive material arranged thereon is spaced between the first and the second magnet, and the first and second magnet are arranged such that a pole of the first magnet faces the opposite pole of the second magnet, and wherein the non-conductive medium, when an electrical current passes between two terminals connected by a layer of linear conductive paths, is movable.

Another embodiment of the invention provides a method for manufacturing a non-conductive medium with a pattern of electrically conductive material arranged thereon, movable when positioned in a magnetic field, said method comprising the steps of arranging a first layer of a plurality of linear conductive paths on the non-conductive medium parallel to a first axis, arranging at least a first and a second terminal on the non-conductive medium, such that each of said plurality of linear conductive paths connects the at least first and second terminal, and wherein the step of arranging the first, when the system is positioned in a magnetic field that is perpendicular to a plane of the first layer of linear conductive paths, and layer of a plurality of linear conductive paths is such that the first layer, when an electrical current flows between the at least first and second terminal, generates an electromagnetic force such that the non-conductive medium moves along a second axis that is perpendicular to the first axis, said method further characterized according to claim 24.

### Brief Description of the Figures

- **Fig. 1**: is a perspective view of an optical pickup actuator according to the state of the art;
- **Fig. 2**: is a perspective view of a portion of the optical pickup actuator shown in Fig. 1;
- **Fig. 3**: is a perspective view of a printed circuit board arranged between two eight-pole magnets in the optical pickup actuator shown in Fig. 1;
- **Fig. 4a**: is an overview of a first layer of a multi-layered arrangement of magnetic circuits;
- **Fig. 4b**: is an overview of a second layer of a multi-layered arrangement of magnetic circuits;
- **Fig. 4c**: is an overview of a third layer of a multi-layered arrangement of magnetic circuits;
- **Fig. 4d**: is an overview of a fourth layer of a multi-layered arrangement of magnetic circuits;
- **Fig. 5**: is a schematical view of a portion of a printed circuit board according to the state of the art;
- **Fig. 6**: shows an overview of one side of a printed circuit board;
- **Fig. 7**: shows an overview of the other side of the printed circuit board shown in Fig. 6.
- **Fig. 8**: shows a perspective view of a system comprising a printed circuit board according to an embodiment of the invention spaced between two magnets;
- **Fig. 9a**: shows an overview of a printed circuit board;
- **Fig. 9b**: is a schematic side view of the printed circuit board shown in Fig. 9a showing the different layers of the printed circuit board;
- **Fig. 10**: shows an overview of one side of a printed circuit board;
- **Fig. 11**: shows an overview of the other side of the printed circuit board shown in Fig. 10 according to an embodiment of the present invention.

### Detailed Description

Reference will now be made in detail to the embodiments of the invention, examples of which are illustrated in the accompanying drawings, wherein like reference numerals refer to the like elements throughout. The embodiments are described below in order to explain the invention by referring to the figures.

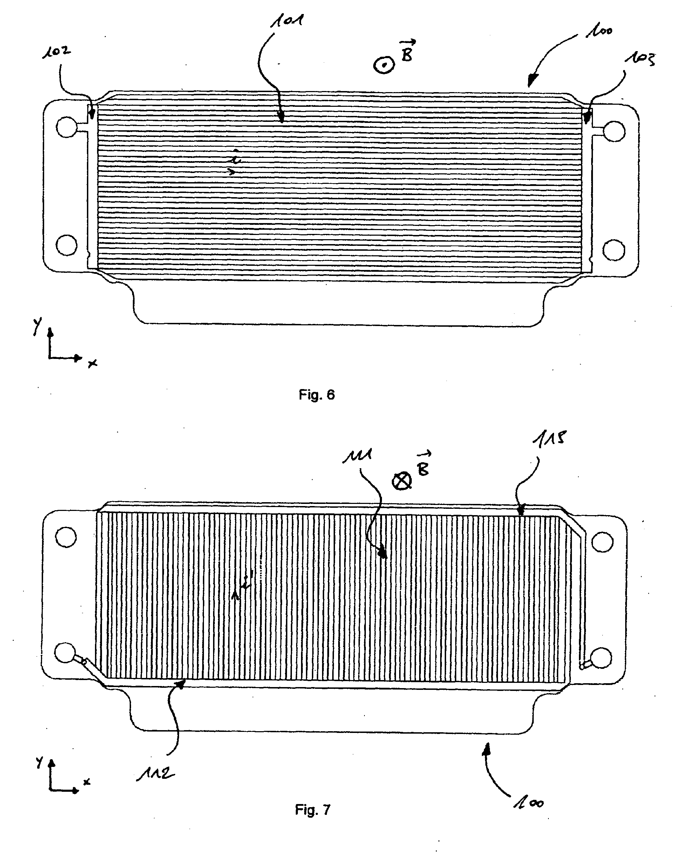

Fig. 6 shows an overview of a printed circuit board 100 according to an embodiment of the invention. A non-conductive medium has a pattern of electrically conductive material arranged on a surface thereof. The non-conductive medium may comprise an epoxy layer or a resin. The pattern of electrically conductive material is preferentially printed on the surface of the non-conductive medium.

Fig. 6 shows an overview of one side of the printed circuit board 100, wherein a layer of a plurality of linear conductive paths 101 is arranged on the non-conductive medium parallel to a first axis, which is along the x-direction shown in Fig. 6. The plurality of linear conductive paths 101 connect a first terminal 102 to a second terminal 103 that are arranged on both sides of the non-conductive medium.

Fig. 7 shows the other side of the printed circuit board 100 represented in Fig. 6. The non-conductive medium has a second layer of a plurality of conductive paths 111 that are arranged on the surface of the non-conductive medium along a second axis that is along the y-direction represented in Fig. 7, i.e. perpendicular to the x-direction. The linear conductive paths 111 connect a third terminal 112 to a fourth terminal 113 arranged on the non-conductive medium.

The first layer of first linear conductive paths 101 arranged on a first side of the non-conductive medium shown in Fig. 6 forms a focus layer, as the first linear conductive paths 101, when an electrical current i flows between the first terminal 102 and the second terminal 103 and a magnetic field B is applied that is perpendicular to the plane of the first linear conductive paths 101, generate an electromagnetic force that is along the second axis, i.e. along the y-direction. This allows for moving the printed circuit board 100 along the focusing direction, i.e. the y-direction.

The second linear conductive paths 111, when an electrical current i' flows from the third terminal 112 to the fourth terminal 113, and a magnetic field B, as in the example described with respect to Fig. 6, is perpendicular to the plane of the second layer of linear conductive paths 111, generate an electromagnetic force that is along the first axis, i.e. the x-direction. Consequently, the printed circuit board 100 is movable along the tracking direction.

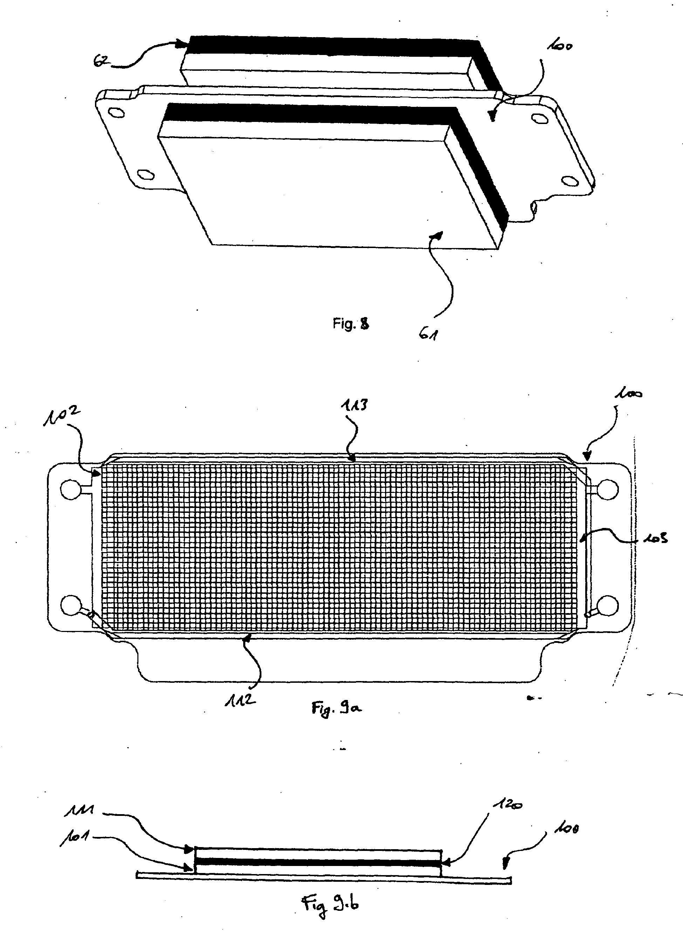

In the examples shown in Figs. 6 and 7, it has been explained that a magnetic field is applied that is perpendicular to a plane of the plurality of first linear conductive paths 101 and to the plane of the plurality of second linear conductive paths 111. This can be achieved using a system as shown in Fig. 8, wherein a circuit board 100 according to an embodiment of the invention is spaced between a first magnet 61 and a second magnet 62. The first magnet 61 and second magnet 62 are two-pole magnets, wherein the one pole of the first magnet 61 faces the opposite pole of the second magnet 62. In the example shown in Fig. 8, the north pole of the first magnet 61 is represented in black and faces the south pole, represented in white, of the second magnet 62.

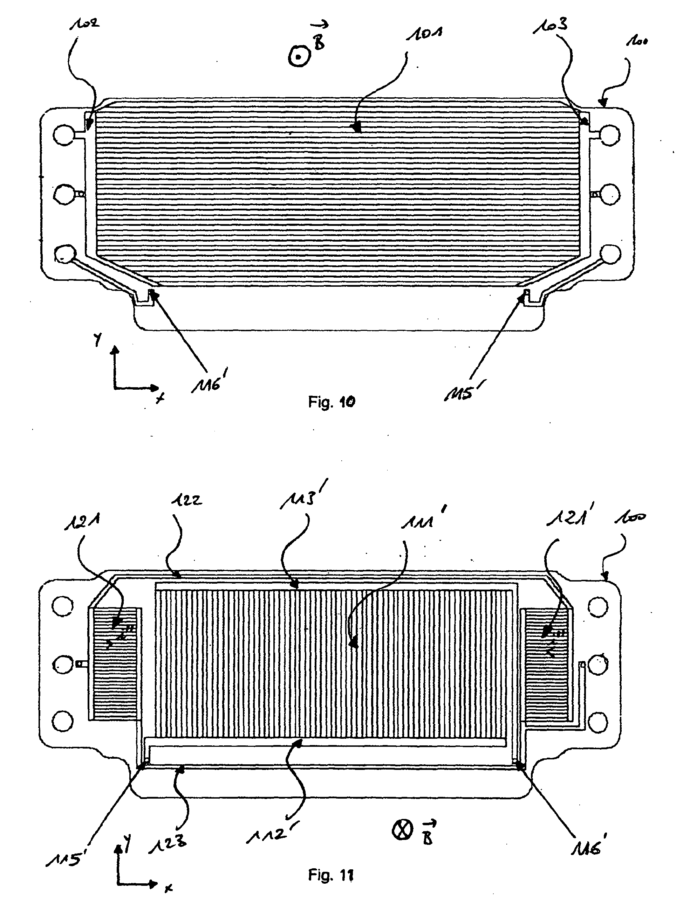

The system shown in Fig. 8 comprising a printed circuit board 100 according to the embodiment shown in Figs. 6 and 7 provides the tracking and focusing functions when implemented in an optical pickup actuator, but does not provide a tilt function. Another embodiment of the invention will be described with respect to Figs. 10 and 11, which allows to support the tilt function in an optical pickup actuator.

Fig. 9a shows an alternative embodiment of the invention, wherein the first layer of first linear conductive paths 101 shown in Fig. 6 and the second layer of second linear conductive paths 111 shown in Fig. 7 are not arranged each on one side of the printed circuit board 100, but are both arranged on one side of the printed circuit board 100. This arrangement is shown in Fig. 9a, which shows a transparent overview of the arrangement of the first and second layers.

Fig. 9b shows a side view of the arrangement of the first and second layer. From Fig. 9b, it is apparent that the first layer of first linear conductive paths 101 is arranged directly on the surface of the non-conductive medium, and that a non-conductive layer 120 is arranged on the surface of the first layer of first linear conductive paths 101. The second layer of second linear conductive paths 111 is arranged on the surface of the non-conductive layer 120. Even though an arrangement has been described, wherein the first layer of first linear conductive paths 101 is arranged directly on the non-conductive medium, and the second layer of second linear conductive paths 111 is arranged as a second layer on top of the first one, it may also be considered to first arrange the second layer of second linear conductive paths 111 directly on the surface of the non-conductive medium, and the first layer of the first linear conductive paths 101 on top of it.

The multi-layered structure made up of the first and second layer shown in Fig. 9b can be arranged not only on one side of the non-conductive medium, but also on both sides thereof. In doing so, the total thickness of the multi-layered arrangement becomes larger, however, the electromagnetic force that is generated can be strengthened through the increased amount of current flowing through the linear conductive paths thanks to the redundant layers of conductive paths.

Figs. 10 and 11 show a printed circuit board 100 according to another embodiment of the invention. The shown printed circuit board 100 has a first, second, third and fourth layer of linear conductive paths such that a tracking, focusing and also tilt function are supported.

Fig. 10 shows a side of the printed circuit board 100, wherein a first layer of first linear conductive paths 101 is arranged on the non-conductive medium along the x-direction, in a similar way to the arrangement shown in Fig. 6. A first terminal 102 and a second terminal 103 are connected to each other through the plurality of first linear conductive paths 101.

Fig 11 shows the other side of the printed circuit board 100, wherein a second layer of second linear conductive paths 111' is arranged on the non-conductive medium along the y-direction. A third terminal 112' and fourth terminal 113' are connected to each other through the plurality of second linear conductive paths 111'.

The first terminal 102 and second terminal 103 are preferentially forseen in the form of conductive strips that extend on both extremities of the first side of the non-conductive medium shown in Fig. 10, essentially along the y-direction, i.e. perpendicular to the direction along which the plurality of linear conductive paths 101 extend. Likewise, the third terminal 112' and fourth terminal 113' are preferentially conductive strips that extend along the x-direction shown in Fig. 11, i.e. perpendicular to the direction along which the plurality of second linear conductive paths 111' are arranged on the other side of the non-conductive medium. Further, the third terminal 112' and fourth terminal 113' are respectively connected to a terminal on which the actual signal is input through the respective first through hole 115' and second through hole 116'.

As apparent from Fig. 11, a third layer of linear conductive paths 121 as well as a fourth layer of fourth linear conductive paths 121' are arranged on the non-conductive medium in the same plane as the second layer of second linear conductive paths 111'. The third and fourth layers of respective third and fourth linear conductive paths 121, 121' are arranged on the opposite ends of the non-conductive medium.

The third layer of linear conductive paths 121 connects a fifth terminal 122 to a sixth terminal 123. Likewise, the fourth layer of linear conductive paths 121' connects the fifth terminal 122 to the sixth terminal 123. The fifth and sixth terminals 122, 123 are arranged in such a way that, when an electrical current I" flows from the fifth terminal 122 to the sixth terminal 123, an electromagnetic force is generated by the third layer of linear conductive paths 121 that has an opposed direction to the electromagnetic force generated by the fourth layer of linear conductive paths 121'.

Hence, when an electrical current I" flows between the fifth and sixth terminal 122, 123, and a magnetic field B is applied whose direction is e.g. perpendicular to the plane of the third and fourth layer of linear conductive paths 121, 121', as is the case when the printed circuit board 100 is spaced between the first and second magnets 61, 62 shown in Fig. 8, the printed circuit board 100 rotates about an axis that is perpendicular to the surface of the printed circuit board 100. Consequently, a tilt function of the printed circuit board 100 can be implemented, further to the focusing function, provided by the first layer of first linear conductive paths 101, and the tracking function, provided by the second layer of second linear conductive paths 111', which have already been described with respect to Figs. 6 and 7.

The third layer of linear conductive paths 121 and the fourth layer of linear conductive paths 121' are arranged symmetrically with respect to the axis about which the printed circuit board is rotatable. The fifth terminal 122 is arranged on the printed circuit board 110 in such a way that the fifth terminal 122 connects the farthest ends, from the rotation axis, of the linear conductive paths 121 of the third layer and linear conductive paths 121' of the fourth layer. The sixth terminal 123 is such that it connects the nearest ends, from the rotation axis, of the linear conductive paths 121 of the third layer and the linear conductive paths 121' of the fourth layer. With such an arrangement, when an electrical current I" flows between the fifth terminal 122 and the sixth terminal 123, and a magnetic field B is perpendicular to the surface of the printed circuit board 100, the linear conductive paths 121 of the third layer and the linear conductive paths 121' of the fourth layer generate respective electromagnetic forces that have opposed directions such that the printed circuit board 100 rotates about the rotation axis perpendicular to the plane of the printed circuit board 100.

According to the embodiment of the invention described in Figs. 10 and 11, the first layer of first linear conductive paths 101 is arranged in a first plane which is on a side of the printed circuit board 100. The second, third and fourth layers of linear conductive paths 111', 121 and 121' are arranged in a second plane which is on the other side of the printed circuit board 100. However, it may also be considered to foresee the first layer of linear conductive paths 101 in the same plane as the third and fourth layer of linear conductive paths 121, 121'.

According to another embodiment of the invention, the first plane and second plane, in which the first, second, third and fourth layers of linear conductive paths 101, 111', 121 and 121' are arranged, are separated by a non-conductive layer, and the set of the first plane and second plane of respective linear conductive paths, separated by the non-conductive layer, is arranged on one side of the non-conductive medium. According to yet another embodiment of the invention, the set of the first and second plane is arranged on both sides of the non-conductive medium.

The different embodiments of the invention allow to simplify the design of magnets employed in an optical pickup actuator, while improving the magnetic efficiency of the magnetic circuits on the printed circuit board arranged in the optical pickup actuator. In particular, the linear conductive paths arranged on the printed circuit board according to an embodiment of the invention form magnetic domains, which total surface contributes to the creation of an electromagnetic force, contrary to the printed circuit board according to the state of the art, which has domains that do not contribute to the creation of an electromagnetic force.

While the description focused on the implementation of a printed circuit board in an optical pickup actuator, it is also possible to consider other applications, such as electrical motors, electrical regulators or other applications.

## Claims

1. A system comprising:
a non-conductive medium with a pattern of electrically conductive material arranged thereon,
wherein said pattern of electrically conductive material comprises a first layer of a plurality of linear conductive paths (101) arranged on the non-conductive medium parallel to a first axis, and
each of said plurality of linear conductive paths (101) connects at least a first terminal (102) and a second terminal (103) arranged on the non-conductive medium,
wherein the linear conductive paths (101), when the system is positioned in a magnetic field that is perpendicular to a plane of the first layer of linear conductive paths (101) and an electrical current (i) flows between the at least first terminal (102) and second terminal (103), are adapted to generate an electromagnetic force such that the non-conductive medium moves along a second axis that is perpendicular to the first axis, thereby obtaining a system that is movable when positioned in a magnetic field;
**characterized by further comprising**
a pair of layers arranged on the non-conductive medium, each layer comprising a plurality of linear conductive paths (121, 121') that are connected to a pair of terminals (122, 123) arranged on the non-conductive medium,
wherein when the system is positioned in the magnetic field and an electrical current (i") flows between the pair of terminals (122, 123), each of the plurality of linear conductive paths (121, 121') of said pair of layers are adapted to generate respective electromagnetic forces having an opposed direction such that the non-conductive medium rotates about an axis that is perpendicular to a plane of the non-conductive medium.

2. The system according to claim 1, further comprising a second layer of a plurality of second linear conductive paths (111),
wherein the plurality of second linear conductive paths (111) of the second layer are arranged parallel to a third axis, each of said plurality of second linear conductive paths (111) connecting at least a third terminal (112) and a fourth terminal (113) arranged on the non-conductive medium, and
the second linear conductive paths (111), when an electrical current (i') flows between the at least third terminal (112) and fourth terminal (113), are adapted to generate an electromagnetic force such that the non-conductive medium moves along a fourth axis that is perpendicular to the third axis.

3. The system according to claim 2, wherein the first layer of first linear conductive paths (101) lies along a first plane defined by the first axis and the second axis, the second layer of second linear conductive paths (111) lies along a second plane defined by the third axis and the fourth axis, and the first plane is parallel to the second plane.

4. The system according to claim 2 or 3, further comprising a first non-conductive layer (120), that is adapted to electrically insulate the first (101) and second layer of linear conductive paths (111) from one another, wherein the second layer of linear conductive paths (111) is arranged on the first non-conductive layer (120).

5. The system according to claim 4, wherein the first non-conductive layer (120) is an epoxy layer.

6. The system according to any of claims 2 to 5, wherein the set of the first layer of first linear conductive paths (101) and second layer of second linear conductive paths (111) is arranged on each side of the non-conductive medium.

7. The system according to claim 2 or 3, wherein the first layer of linear conductive paths (101) is arranged on one side of the non-conductive medium and the second layer of linear conductive paths (111) is arranged on the other side of the non-conductive medium.

8. The system according to any of claims 2 to 7, wherein the first (102), second (103), third (112) and fourth terminal (113) are a first, second, third and fourth conductive strip, respectively.

9. The system according to any of claims 2 to 8, wherein the first axis of the first layer is arranged perpendicularly to the third axis of the second layer of linear conductive paths (111).

10. The system according to any of claims 2 to 7, wherein:
said pair of layers corresponds to a third and a fourth layer of a plurality of respective third (121) and fourth linear conductive paths (121'), and
said third linear conductive paths (121) and fourth linear conductive paths (121') are arranged on the non-conductive medium parallel respectively to a fifth axis and a sixth axis, and
said pair of terminals (122, 123) to which said third and fourth linear conductive paths both connect corresponds to a fifth terminal (122) and a sixth terminal (123) arranged on the non-conductive medium.

11. The system according to claim 10,
wherein the third and fourth layer of respective third (121) and fourth linear conductive paths (121') are arranged in a same plane parallel to the plane of the non-conductive medium,
the third and fourth layer of linear conductive paths are arranged on opposite ends of the non-conductive medium, and are essentially symmetrical to each other with respect to the seventh axis, and
the fifth and sixth axis are parallel to each other.

12. The system according to claim 11, wherein the fifth terminal (122) is adapted to connect the furthest ends, from the seventh axis, of the fifth (121) and sixth linear conductive paths (121'), and the sixth terminal (123) is adapted to connect the nearest ends, from the seventh axis, of the fifth (121) and sixth linear conductive paths (121'), so that said third (121) and fourth linear conductive paths (121'), when an electrical current flows (i") between the fifth (122) and the sixth terminal (123), generate respective electromagnetic forces such that the non-conductive medium rotates about the seventh axis perpendicular to the plane of the non-conductive medium.

13. The system according to any of claims 10 to 12, wherein the fifth (122) and sixth terminal (123) are a fifth and sixth conductive strip, respectively.

14. The system according to any of claims 10 to 13, wherein the first layer of first linear conductive paths (101) is arranged in a first plane, and the second layer of second linear conductive paths (111) and the third and fourth layer of third (121) and fourth linear conductive paths (121'), respectively, are arranged in a second plane.

15. The system according to any of claims 10 to 13, wherein the first layer of first linear conductive paths (101) and the third and fourth layer of third (121) and fourth linear conductive paths (121'), respectively, are arranged in a third plane and the second layer of second linear conductive paths (111) is arranged in a fourth plane.

16. The system according to claim 14, wherein the first plane and second plane are arranged on one side of the non-conductive medium, and a second non-conductive layer is arranged between the first and second plane.

17. The system according to claim 16, wherein the set of the first and second plane is arranged on each side of the non-conductive medium.

18. The system according to claim 15, wherein the third plane and fourth plane are arranged on one side of the non-conductive medium, and a third non-conductive layer is arranged between the third and fourth plane.

19. The system according to claim 18, wherein the set of the third and fourth plane is arranged on each side of the non-conductive medium.

20. The system according to claim 14, wherein the first plane is arranged on one side of the non-conductive medium, and the second plane is arranged on the other side of the non-conductive medium.

21. The system according to claim 15, wherein the third plane is arranged on one side of the non-conductive medium, and the fourth plane is arranged on the other side of the non-conductive medium.

22. The system according to any of claims 1 to 21, wherein the pattern of electrically conductive material is printed on a surface of the non-conductive medium.

23. The system according to any of claims 1 to 22, further comprising a first magnet (61) and a second magnet (62),
wherein the non-conductive medium with the pattern of electrically conductive material arranged thereon is spaced between the first (61) and the second magnet (62), and the first (61) and second magnet (62) are arranged such that a pole of the first magnet (61) faces the opposite pole of the second magnet (62), and
wherein the non-conductive medium, when an electrical current passes between two terminals connected by a layer of linear conductive paths, is movable.

24. A method for manufacturing a system comprising a non-conductive medium with a pattern of electrically conductive material arranged thereon, said method comprising the following steps:
arranging a first layer of a plurality of linear conductive paths (101) on the non-conductive medium parallel to a first axis,
arranging at least a first (102) and a second terminal (103) on the non-conductive medium, such that each of said plurality of linear conductive paths (101) connects the at least first (102) and second terminal (103), and
wherein the step of arranging the first layer of a plurality of linear conductive paths (101) is such that the first layer (101), when the system is positioned in a magnetic field that is perpendicular to a plane of the first layer of linear conductive paths (101) and an electrical current flows between the at least first (102) and second terminal (103), generates an electromagnetic force such that the non-conductive medium moves along a second axis that is perpendicular to the first axis, thereby obtaining a system that is movable when positioned in a magnetic field;
**characterized by further comprising a step of**
arranging a pair of layers on the non-conductive medium, each layer comprising a plurality of linear conductive paths (121, 121') that are connected to a pair of terminals (122, 123) arranged on the non-conductive medium,
wherein when the system is positioned in the magnetic field and an electrical current (i") flows between the pair of terminals (122, 123), each of the plurality of linear conductive paths (121, 121') of said pair of layers are adapted to generate respective electromagnetic forces having an opposed direction such that the non-conductive medium rotates about an axis that is perpendicular to a plane of the non-conductive medium.

## Patentansprüche

1. System, umfassend:
ein nichtleitendes Medium, auf dem ein Muster aus elektrisch leitfähigem Material angeordnet ist,
wobei das Muster aus elektrisch leitfähigem Material eine erste Schicht aus einer Vielzahl von linearen Leiterbahnen (101) umfasst, die auf dem nichtleitenden Medium parallel zu einer ersten Achse angeordnet sind, und
jede der Vielzahl von linearen Leiterbahnen (101) mindestens einen ersten Anschluss (102) und einen zweiten Anschluss (103), die auf dem nichtleitenden Medium angeordnet sind, verbinden,
wobei die linearen Leiterbahnen (101) ausgestaltet sind, eine elektromagnetische Kraft zu erzeugen, so dass sich das nichtleitende Medium entlang einer zweiten Achse, die senkrecht zu der ersten Achse ist, bewegt, wodurch ein System erhalten wird, das, wenn in einem magnetischen Feld angeordnet, beweglich ist, wenn das System in einem Magnetfeld angeordnet ist, das senkrecht zu einer Ebene der ersten Schicht von linearen Leitbahnen (101) ist und ein elektrischer Strom (i) zwischen dem mindestens ersten Anschluss (102) und zweiten Anschluss (103) fließt;
**dadurch gekennzeichnet, dass es ferner Folgendes umfasst**
ein auf dem nichtleitenden Medium angeordnetes Schichtenpaar, wobei jede Schicht eine Vielzahl von linearen Leiterbahnen (121, 121') umfasst, die mit einem Anschlusspaar (122, 123), das auf dem nichtleitenden Medium angeordnet ist, verbunden sind,
wobei jede der Vielzahl von linearen Leiterbahnen (121, 121') des Schichtenpaares ausgestaltet ist, um jeweilige elektromagnetische Kräfte mit einer entgegengesetzten Richtung zu erzeugen, so dass sich das nichtleitende Medium um eine Achse dreht, die senkrecht zu einer Ebene des nichtleitenden Mediums ist, wenn das System in dem Magnetfeld angeordnet ist und ein elektrischer Strom (i") zwischen dem Anschlusspaar (122, 123) fließt.

2. System nach Anspruch 1, ferner umfassend eine zweite Schicht aus einer Vielzahl von zweiten linearen Leiterbahnen (111),
wobei die Vielzahl von zweiten linearen Leiterbahnen (111) der zweiten Schicht parallel zu einer dritten Achse angeordnet ist, wobei jede der Vielzahl von zweiten linearen Leiterbahnen (111) mindestens einen dritten Anschluss (112) und einen vierten Anschluss (113), die auf dem nichtleitenden Medium angeordnet sind, verbindet, und
die zweiten linearen Leiterbahnen (111) ausgestaltet sind, eine elektromagnetische Kraft zu erzeugen, so dass sich das nichtleitende Medium entlang einer vierten Achse, die senkrecht zu der dritten Achse ist, bewegt, wenn ein elektrischer Strom (1') zwischen dem mindestens dritten Anschluss (112) und vierten Anschluss (113) fließt.

3. System nach Anspruch 2, wobei die erste Schicht erster linearer Leiterbahnen (101) entlang einer ersten Ebene liegt, die durch die erste Achse und die zweite Achse definiert ist, die zweite Schicht zweiter linearer Leiterbahnen (111) entlang einer zweiten Ebene liegt, die durch die dritte Achse und die vierte Achse definiert ist, und die erste Ebene parallel zu der zweiten Ebene ist.

4. System nach Anspruch 2 oder 3, ferner umfassend eine erste nichtleitende Schicht (120), die ausgestaltet ist, die erste (101) und zweite Schicht aus linearen Leiterbahnen (111) voneinander elektrisch zu isolieren, wobei die zweite Schicht linearer Leiterbahnen (111) auf der ersten nichtleitenden Schicht (120) angeordnet ist.

5. System nach Anspruch 4, wobei die erste nichtleitende Schicht (120) eine Epoxy-Schicht ist.

6. System nach einem der Ansprüche 2 bis 5, wobei der Satz der ersten Schicht erster linearer Leiterbahnen (101) und der zweiten Schicht zweiter linearer Leiterbahnen (111) beidseits des nichtleitenden Mediums angeordnet ist.

7. System nach Anspruch 2 oder 3, wobei die erste Schicht linearer Leiterbahnen (101) auf einer Seite des nichtleitenden Mediums angeordnet ist und die zweite Schicht linearer Leiterbahnen (111) auf der anderen Seite des nichtleitenden Mediums angeordnet ist.

8. System nach einem der Ansprüche 2 bis 7, wobei der erste (102), zweite (103), dritte (112) und vierte Anschluss (113) ein erster, zweiter, dritter bzw. vierter Leiterstreifen ist.

9. System nach einem der Ansprüche 2 bis 8, wobei die erste Achse der ersten Schicht senkrecht zur dritten Achse der zweiten Schicht linearer Leiterbahnen (111) angeordnet ist.

10. System nach einem der Ansprüche 2 bis 7, wobei:
das Schichtenpaar einer dritten und einer vierten Schicht einer Vielzahl von jeweiligen dritten (121) und vierten linearen Leiterbahnen (121') entspricht, und
die dritten linearen Leiterbahnen (121) und die vierten linearen Leiterbahnen (121') auf dem nichtleitenden Medium jeweils parallel zu einer fünften Achse und einer sechsten Achse angeordnet sind, und
das Anschlusspaar (122, 123), mit dem die dritten und vierten linearen Leiterbahnen jeweils verbunden sind, einem fünften Anschluss (122) und einem sechsten Anschluss (123) entsprechen, die auf dem nichtleitenden Medium angeordnet sind.

11. System nach Anspruch 10,
wobei die dritte und vierte Schicht der jeweiligen dritten (121) und vierten linearen Leiterbahnen (121') in einer gleichen Ebene parallel zu der Ebene des nichtleitenden Medium angeordnet sind,
die dritte und vierte Schicht linearer Leiterbahnen auf gegenüberliegenden Enden des nichtleitenden Medium angeordnet sind, und im Wesentlichen symmetrisch zueinander in Bezug auf die siebte Achse sind, und
die fünfte und sechste Achse parallel zueinander sind.

12. System nach Anspruch 11, wobei der fünfte Anschluss (122) ausgestaltet ist, die von der siebten Achse am weitest entfernten Enden der fünften (121) und sechsten linearen Leiterbahnen (121') zu verbinden und der sechste Anschluss (123) ausgestaltet ist, um die der siebten Achse nächstgelegenen Enden der fünften (121) und sechsten linearen Leiterbahnen (121') zu verbinden, so dass die dritten (121) und vierten linearen Leiterbahnen (121') jeweilige elektromagnetische Kräfte erzeugen, so dass sich das nichtleitende Medium um die siebte Achse senkrecht zu der Ebene des nichtleitenden Mediums dreht, wenn ein elektrischer Strom (i") zwischen dem fünften (122) und dem sechsten Anschluss (123) fließt.

13. System nach einem der Ansprüche 10 bis 12, wobei der fünfte (122) und sechste Anschluss (123) ein fünfter bzw. sechster Leiterstreifen sind.

14. System nach einem der Ansprüche 10 bis 13, wobei die erste Schicht erster linearer Leiterbahnen (101) in einer ersten Ebene angeordnet ist, und die zweite Schicht zweiter linearer Leiterbahnen (111) und die dritte und vierte Schicht dritter (121) bzw. vierter linearer Leiterbahnen (121') in einer zweiten Ebene angeordnet sind.

15. System nach einem der Ansprüche 10 bis 13, wobei die erste Schicht erster linearer Leiterbahnen (101) und die dritte und vierte Schicht dritter (121) und vierter linearer Leiterbahnen (121') jeweils in einer dritten Ebene angeordnet sind und die zweite Schicht zweiter linearer Leiterbahnen (111) in einer vierten Ebene angeordnet ist.

16. System nach Anspruch 14, wobei die erste Ebene und die zweite Ebene auf einer Seite des nichtleitenden Mediums angeordnet sind, und eine zweite nichtleitende Schicht zwischen der ersten und zweiten Ebene angeordnet ist.

17. System nach Anspruch 16, wobei der Satz der ersten und zweiten Ebene beidseits des nichtleitenden Mediums angeordnet ist.

18. System nach Anspruch 15, wobei die dritte Ebene und die vierte Ebene auf einer Seite des nichtleitenden Mediums angeordnet sind, und eine dritte nichtleitende Schicht zwischen der dritten und vierten Ebene angeordnet ist.

19. System nach Anspruch 18, wobei der Satz der dritten und vierten Ebene beidseits des nichtleitenden Mediums angeordnet ist.

20. System nach Anspruch 14, wobei die erste Ebene auf einer Seite des nichtleitenden Mediums angeordnet ist, und die zweite Ebene auf der anderen Seite des nichtleitenden Mediums angeordnet ist.

21. System nach Anspruch 15, wobei die dritte Ebene auf einer Seite des nichtleitenden Mediums angeordnet ist, und die vierte Ebene auf der anderen Seite des nichtleitenden Mediums angeordnet ist.

22. System nach einem der Ansprüche 1 bis 21, wobei das Muster aus elektrisch leitendem Material auf einer Oberfläche des nichtleitenden Mediums gedruckt ist.

23. System nach einem der Ansprüche 1 bis 22, ferner umfassend einen ersten Magneten (61) und einen zweiten Magneten (62),
wobei das nichtleitende Medium mit dem darauf angeordneten Muster von elektrisch leitendem Material zwischen dem ersten (61) und dem zweiten Magneten (62) beabstandet ist, und der erste (61) und der zweite Magnet (62) derart angeordnet sind, dass ein Pol des ersten Magneten (61) dem entgegengesetzten Pol des zweiten Magneten (62) gegenüberliegt, und
wobei das nichtleitende Medium beweglich ist, wenn ein elektrischer Strom zwischen zwei Anschlüssen, die durch eine Schicht linearer Leiterbahnen verbunden sind, fließt.

24. Verfahren zur Herstellung eines Systems, das ein nichtleitendes Medium mit einem Muster von darauf angeordnetem elektrisch leitendem Material umfasst, wobei das Verfahren die folgenden Schritte umfasst:
Anordnen einer ersten Schicht einer Vielzahl von linearen Leiterbahnen (101) auf dem nichtleitenden Medium parallel zu einer ersten Achse,
Anordnen mindestens eines ersten (102) und eines zweiten Anschlusses (103) auf dem nichtleitenden Medium, so dass jede der Vielzahl von linearen Leiterbahnen (101) den mindestens ersten (102) und zweiten Anschluss (103) verbindet, und
wobei der Schritt des Anordnens der ersten Schicht einer Vielzahl von linearen Leiterbahnen (101) derart ist, dass die erste Schicht (101) eine elektromagnetische Kraft erzeugt, so dass sich das nichtleitende Medium entlang einer zweiten Achse, die senkrecht zu der ersten Achse ist, bewegt, wodurch ein System erhalten wird, das, wenn in einem magnetischen Feld angeordnet, beweglich ist, wenn das System in einem Magnetfeld angeordnet ist, das senkrecht zu einer Ebene der ersten Schicht von linearen Leitbahnen (101) ist und ein elektrischer Strom zwischen dem mindestens ersten (102) und zweiten Anschluss (103) fließt;
**dadurch gekennzeichnet, dass es ferner folgenden Schritt umfasst:**
Anordnen eines Schichtenpaares auf dem nichtleitenden Medium, wobei jede Schicht eine Vielzahl von linearen Leiterbahnen (121, 121') umfasst, die mit einem Anschlusspaar (122, 123) verbunden sind, das auf dem nichtleitenden Medium angeordnet ist,
wobei jede der Vielzahl von linearen Leiterbahnen (121, 121') des Schichtenpaares ausgestaltet ist, um jeweilige elektromagnetische Kräfte mit einer entgegengesetzten Richtung zu erzeugen, so dass sich das nichtleitende Medium um eine Achse dreht, die senkrecht zu einer Ebene des nichtleitenden Mediums ist, wenn das System in dem Magnetfeld angeordnet ist und ein elektrischer Strom (i") zwischen dem Anschlusspaar (122, 123) fließt.

## Revendications

1. Système comprenant:
un milieu non-conducteur avec un motif de matériau électriquement conducteur disposé sur celui-ci,
ledit motif de matériau électriquement conducteur comprenant une première couche d'une pluralité de pistes conductrices linéaires (101) disposée sur le milieu non-conducteur parallèlement à un premier axe, et
chacune de ladite pluralité de pistes conductrices linéaires (101) connectant au moins un premier terminal (102) et un deuxième terminal (103) disposés sur le milieu non-conducteur,
lesdites pistes conductrices linéaires (101), lorsque le système est positionné dans un champ magnétique qui est perpendiculaire à un plan de la première couche de pistes conductrices linéaires (101) et qu'un courant électrique (i) passe entre l'au moins premier terminal (102) et deuxième terminal (103), étant adaptées pour générer une force électromagnétique de sorte que le milieu non-conducteur se déplace le long d'un deuxième axe qui est perpendiculaire au premier axe, créant ainsi un système qui est mobile lorsqu'il est placé dans un champ magnétique;
**caractérisé par comprenant en outre**
une paire de couches disposées sur le milieu non-conducteur, chaque couche comprenant une pluralité de pistes conductrices linéaires (121, 121') qui sont connectées à une paire de terminaux (122, 123) disposée sur le milieu non-conducteur,
dans lequel, lorsque le système est positionné dans le champ magnétique et qu'un courant électrique (i") passe entre la paire de terminaux (122, 123), chacune de la pluralité des pistes conductrices linéaires (121, 121') de ladite paire de couches est adaptée pour générer des forces électromagnétiques respectives ayant une direction opposée de sorte que le milieu non-conducteur pivote autour d'un axe qui est perpendiculaire à un plan du milieu non-conducteur.

2. Système selon la revendication 1, comprenant en outre une deuxième couche d'une pluralité de deuxièmes pistes conductrices linéaires (111),
dans lequel la pluralité des deuxième pistes conductrices linéaires (111) de la deuxième couche est disposée en parallèle à un troisième axe, chacune de ladite pluralité des deuxième pistes conductrices linéaires (111) connectant au moins un troisième terminal (112) et un quatrième terminal (113) disposés sur le milieu non-conducteur, et
les deuxièmes pistes conductrices linéaires (111), lorsqu'un courant électrique (i') passe entre l'au moins troisième terminal (112) et quatrième terminal (113), sont adaptées pour générer une force électromagnétique de sorte que le milieu non-conducteur se déplace le long d'un quatrième axe qui est perpendiculaire au troisième axe.

3. Système selon la revendication 2, dans lequel la première couche des premières pistes conductrices linéaires (101) se situe le long d'un premier plan défini par le premier axe et le deuxième axe, la deuxième couche des deuxièmes pistes conductrices linéaires (111) se situant le long d'un deuxième plan défini par le troisième axe et le quatrième axe, le premier plan étant parallèle au deuxième plan.

4. Système selon la revendication 2 ou la revendication 3, comprenant en outre une première couche non-conductrice (120), qui est adaptée pour isoler électriquement la première (101) et la deuxième couche de pistes conductrices linéaires (111) l'une de l'autre, dans lequel la deuxième couche de pistes conductrices linéaires (111) est disposée sur la première couche non-conductrice (120).

5. Système selon la revendication 4, dans lequel la première couche non-conductrice (120) est une couche d'époxy.

6. Système selon l'une quelconque des revendications 2 à 5, dans lequel le jeu de la première couche de premières pistes conductrices linéaires (101) et la deuxième couche de deuxièmes pistes conductrices linéaires (111) est disposé sur chaque côté du milieu non-conducteur.

7. Système selon la revendication 2 ou la revendication 3, dans lequel la première couche de pistes conductrices linéaires (101) est disposée sur un côté du milieu non-conducteur et la deuxième couche de pistes conductrices linéaires (111) est disposée sur l'autre côté du milieu non-conducteur.

8. Système selon l'une quelconque des revendications 2 à 7, dans lequel le premier (102), le deuxième (103), le troisième (112) et le quatrième terminaux (113) sont une première, deuxième, troisième et quatrième bandes conductrices, respectivement.

9. Système selon l'une quelconque des revendications 2 à 8, dans lequel le premier axe de la première couche est disposé perpendiculairement au troisième axe de la deuxième couche de pistes conductrices linéaires (111).

10. Système selon l'une quelconque des revendications 2 à 7, dans lequel:
ladite paire de couches correspond à une troisième et une quatrième couche d'une pluralité de troisième (121) et quatrième pistes conductrices linéaires (121') respectives, et
lesdites troisième pistes conductrices linéaires (121) et quatrième pistes conductrices linéaires (121') sont disposées sur le milieu non-conducteur en parallèle, respectivement, à un cinquième axe et une sixième axe, et
ladite paire de terminaux (122, 123) auxquels se connectent lesdites troisième et quatrième pistes conductrices linéaires correspond à un cinquième terminal (122) et un sixième terminal (123) disposés sur le milieu non-conducteur.

11. Système selon la revendication 10,
dans lequel la troisième et la quatrième couche des troisième (121) et quatrième pistes conductrices linéaires respectives sont disposées dans un même plan parallèle au plan du milieu non-conducteur,
la troisième et quatrième couches de pistes conductrices linéaires sont disposées sur des extrémités opposées du milieu non-conducteur et sont essentiellement symétriques l'une à l'autre par rapport au septième axe, et
le cinquième et sixième axe sont parallèles l'un à l'autre.

12. Système selon la revendication 11, dans lequel le cinquième terminal (122) est adapté pour connecter les extrémités les plus éloignées, à partir du septième axe, de la cinquième (121) et de la sixième pistes conductrices linéaires (121'), et le sixième terminal (123) est adapté pour connecter les extrémités les plus proches, à partir du septième axe, de la cinquième (121) et de la sixième pistes conductrices linéaires (121'), de sorte que lesdites troisième (121) et quatrième pistes conductrices linéaires (121'), lorsqu'un courant électrique (i") passe entre le cinquième (122) et le sixième terminal (123), génèrent des forces électromagnétiques respectives de sorte que le milieu non-conducteur pivote autour du septième axe perpendiculaire au plan du milieu non-conducteur.

13. Système selon l'une quelconque des revendications 10 à 12, dans lequel le cinquième (122) et le sixième terminaux (123) sont les cinquième et sixième bandes conductrices, respectivement.

14. Système selon l'une quelconque des revendications 10 à 13, dans lequel la première couche de première pistes conductrices linéaires (101) est disposée dans un premier plan, et la deuxième couche de deuxième pistes conductrices linéaires (111) et la troisième et quatrième couches (121) de troisième et quatrième pistes conductrices linéaires (121'), respectivement, sont disposées dans un deuxième plan.

15. Système selon l'une quelconque des revendications 10 à 13, dans lequel la première couche de première pistes conductrices linéaires (101) et la troisième et quatrième couches de troisième (121) et quatrième pistes conductrices linéaires (121'), respectivement, sont disposées dans un troisième plan, et la deuxième couche de deuxième pistes conductrices linéaires (111) est disposée dans un quatrième plan.

16. Système selon la revendication 14, dans lequel le premier plan et le deuxième plan sont disposés d'un côté du milieu non-conducteur, et une deuxième couche non-conductrice est disposée entre le premier et le deuxième plan.

17. Système selon la revendication 16, dans lequel le premier jeu du premier et du deuxième plan est disposé sur chaque côté du milieu non-conducteur.

18. Système selon la revendication 15, dans lequel le troisième plan et le quatrième plan sont disposés d'un côté du milieu non-conducteur, et une troisième couche non-conductrice est disposée entre le troisième et le quatrième plan.

19. Système selon la revendication 18, dans lequel le jeu du troisième et quatrième plan est disposé sur chaque côté du milieu non-conducteur.

20. Système selon la revendication 14, dans lequel le premier plan est disposé sur un côté du milieu non-conducteur, et le deuxième plan est disposé de l'autre côté du milieu non-conducteur.

21. Système selon la revendication 15, dans lequel le troisième plan est disposé sur un côté du milieu non-conducteur, et le quatrième plan est disposé de l'autre côté du milieu non-conducteur.

22. Système selon l'une quelconque des revendications 1 à 21, dans lequel le motif de matériau électriquement conducteur est imprimé sur une surface du milieu non-conducteur.

23. Système selon l'une quelconque des revendications 1 à 22, comprenant en outre un premier aimant (61) et un deuxième aimant (62),
dans lequel le milieu non-conducteur avec le motif de matériau électriquement conducteur disposé sur celui-ci est espacé entre le premier (61) et le deuxième aimants (62), et le premier (61) et le deuxième aimant (62) sont disposés tels qu'un pôle du premier aimant (61) fait face au pôle opposé du deuxième aimant (62), et
dans lequel le milieu non-conducteur, lorsque le courant électrique passe entre deux terminaux connectés par une couche de pistes conductrices linéaires, est mobile.

24. Procédé de fabrication d'un système comprenant un milieu non-conducteur avec un motif de matériau électriquement conducteur disposé sur celui-ci, ledit procédé comprenant les étapes suivantes:
la disposition d'une première couche d'une pluralité de pistes conductrices linéaires (101) sur le milieu non-conducteur en parallèle avec un premier axe,
la disposition d'au moins un premier (102) et un deuxième terminal (103) sur le milieu non-conducteur, de sorte que chacune de la pluralité de pistes conductrices linéaires (101) connecte l'au moins premier (102) et deuxième terminal (103), et
dans lequel l'étape de disposition de la première couche d'une pluralité de pistes conductrices linéaires (101) est telle que la première couche (101), lorsque le système est positionné dans un champ magnétique qui est perpendiculaire à un plan de la première couche de pistes conductrices linéaires (101) et qu'un courant électrique passe entre l'au moins premier (102) et deuxième terminal (103), génère une force électromagnétique telle que le milieu non-conducteur se déplace le long d'un deuxième axe qui est perpendiculaire au premier axe créant ainsi un système qui est mobile lorsqu'il est placé dans un champ magnétique ;
**caractérisé par comprenant en outre une étape de**
disposition d'une paire de couches sur le milieu non-conducteur, chaque couche comprenant une pluralité de pistes conductrices linéaires (121, 121') qui sont connectées à une paire de terminaux (122, 123) disposée sur le milieu non-conducteur,
dans lequel, lorsque le système est positionné dans le champ magnétique et qu'un courant électrique (i") passe entre la paire de terminaux (122, 123), chacune de la pluralité de pistes conductrices linéaires (121, 121') de ladite paire de couches est adaptée pour générer des forces électromagnétiques respectives ayant une direction opposée de sorte que le milieu non-conducteur pivote autour d'un axe qui est perpendiculaire à un plan du milieu non-conducteur.
